# EUROPEAN PATENT APPLICATION

(11) **EP 2 472 280 A2**
(43) Date of publication of application: **04.07.2012**
(21) Application number: 11195853.4
(22) Date of filing: 28.12.2011
(51) Int. Cl.: G01R 33/09, H01L 43/08

(54) **Magnetoresistive sensor**

(30) Priority: 31.12.2010 TW 099147343; 22.02.2011 TW 100105859
(71) Applicant: Voltafield Technology Corporation, Jhubei City, Hsinchu County 30288 (TW)
(72) Inventor: Liou, Fu-Tai, 30288 Jhubei City, Hsinchu County (TW); Fu, Nai-Chung, 330288 Jhubei City, Hsinchu County (TW); Lee, Chien-Min, 30288 JHUBEI CITY, HSINCHU COUNTY (TW)
(74) Representative: Reichert, Sabine

(57) **Abstract**

A magnetoresistive sensor (100) is provided, which includes a substrate (202), a first conductive trace (206), and a magnetoresistive structure (212). The first conductive trace (206) is configured on the substrate (202), and the first conductive trace (206) has a first surface and a second surface opposite to the first surface, the first surface facing toward the substrate (202). The magnetoresistive structure (212) is configured on the second surface and electrically connected to the first conductive trace (206).

## Description

### FIELD OF THE INVENTION

The present invention relates to a magnetoresistive sensor and more particularly to a magnetoresistive sensor with improved sensitivity and manufacturability.

### BACKGROUND OF THE INVENTION

With the development of consumer electronic products such as mobile phones and electronic compasses, additionally together with conventional products such as motors and brakes, the demand of magnetoresistive sensors is progressively increasing.

Typically, a magnetoresistive sensor includes a substrate, a magnetoresistive structure formed on the substrate and at least one conductive layer formed on the magnetoresistive structure, and in a conventional process for fabricating the magnetoresistive sensor, the magnetoresistive structure is firstly formed prior to the metallization process for forming the magnetoresistive structure. Such processing sequence leaves a high risk of cross contamination either to the backend equipments or front-end devices (in the substrate) due to the outward diffusion of the magnetic elements (for example iron, cobalt and nickel) in the magnetoresistive structure. The other concern of the conventional processes arises from thermal and stress accumulation from the subsequent metallization processes, such as forming the conductive layer. The performance and reliability of the magnetoresistive structure may also get worse under such circumstances.

### SUMMARY OF THE INVENTION

Therefore, an objective of the present invention is to provide a magnetoresistive sensor with improved sensitivity for sensing a change of external magnetic field. Another objective of the present invention is to provide a magnetoresistive sensor with improved manufacturability to prevent cross contamination either to the backend equipments or front-end devices, and thermal and stress accumulation from the metallization processes.

In order to achieve the objective, a magnetoresistive sensor of the present invention primarily may have a conductive trace that is formed prior to a magnetoresistive structure.

More specifically, a magnetoresistive sensor in accordance with an embodiment of the present invention includes a substrate, a first conductive trance, and a magnetoresistive structure. The first conductive trace is configured on the substrate, the first conductive trace has a first surface and a second surface opposite to the first surface, and the first surface faces toward the substrate. The magnetoresistive structure is configured on the second surface and electrically connected to the first conductive trace.

For the magnetoresistive sensor of the present invention, since the general semiconductor devices such as the conductive trace are firstly formed on the substrate, the metallic pollution issue caused by the magnetic material such as iron, cobalt and nickel in subsequent process during the conventional fabrication process of magnetoresistive sensor can be avoided, and the influence of magnetoresistive structure reliability caused by the change of temperature and/or stress in the subsequent process, the etching process or the lithography process also can be avoided.

Moreover, in the magnetoresistive sensor of the present invention, the hard mask layer only is needed for defining the magnetoresistance layer and no longer needed to resist from the etching of defining the conductive trace, and therefore the hard mask layer may have a thinner thickness than that in the conventional magnetoresistive structure. Accordingly, the magnetoresistive structure with a thinner hard mask layer can improve the sensitivity of sensing the change of external magnetic field.

### BRIEF DESCRIPTION OF THE DRAWINGS

The above objects and advantages of the present invention will become more readily apparent to those ordinarily skilled in the art after reviewing the following detailed description and accompanying drawings, in which:

FIG. 1 shows a schematic cross-sectional view of a magnetoresistive sensor in accordance with a first embodiment of the present invention;

FIG. 2 shows a schematic cross-sectional view of a magnetoresistive sensor in accordance with a second embodiment of the present invention;

FIG. 2A shows a cross-sectional, schematic view illustrating a partial process flow of a fabricating method of a magnetoresistive sensor process for the magnetoresistive sensor of FIG. 1;

FIG. 3A shows a schematic cross-sectional view of a magnetoresistive sensor in accordance with a third implementation of a first embodiment of the present invention;

FIG. 3B shows a schematic top view of the magnetoresistive sensor as shown in FIG. 3A;

FIG. 4A shows a schematic top view of a magnetoresistive sensor in accordance with a second implementation of the third embodiment of the present invention;

FIG. 4B shows a schematic cross-sectional view of the magnetoresistive sensor as shown in FIG. 4A;

FIGS. 5A and 5B show schematic cross-sectional views of magnetoresistive sensors in accordance with third and fourth implementations of the third embodiment of the present invention;

FIGS. 5C and 5D show schematic cross-sectional views of magnetoresistive sensors respectively in accordance with fifth and sixth implementations of the third embodiment of the present invention;

FIGS. 5E and 5F show schematic cross-sectional views of magnetoresistive sensors respectively in accordance with seventh and eighth implementations of the third embodiment of the present invention;

### DETAILED DESCRIPTION OF PREFERRED EMBODIMENTS

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

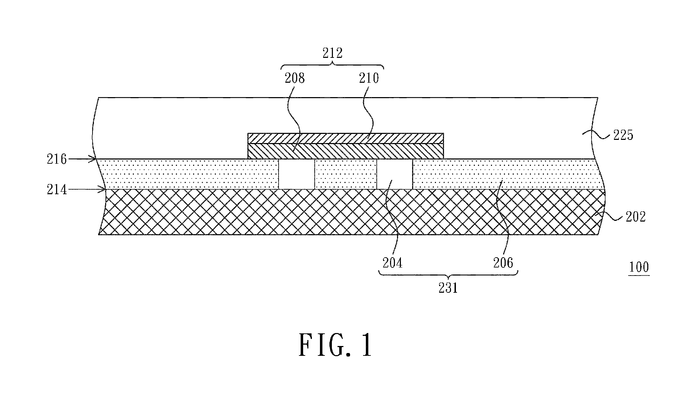

Fig. 1 is a cross-sectional, schematic view of a magnetoresistive sensor in accordance with an embodiment of the present invention. Referring to Fig. 1, a magnetoresistive sensor 100 includes a substrate 202, a conductive unit 231 and a magnetoresistive structure 212. The substrate 202 can be either a silicon substrate covered by a dielectric material or a silicon chip having previously formed logic circuits. The conductive unit 231 is configured on the substrate 202. The conductive unit 231 includes a plurality of routing conductive traces, and has a first insulating layer 204 formed on the substrate 202 and a first conductive layer 206 configured in the first insulating layer 204. In the present embodiment, the first conductive layer 206 constitutes the routing conductive traces. The first conductive layer 206 is electrically connected to the magnetoresistive structure 212. A material of the first conductive layer 206 can be either tungsten or copper.

The conductive unit 231 has a first surface 214 and a second surface 216 on an opposite side of the conductive unit 231 to the first surface 214. The first surface 214 faces the substrate 202. The magnetoresistive structure 212 is configured on the second surface 216 of the conductive unit 231 and is electrically connected to the conductive unit 231. In detail, the magnetoresistive structure 212 includes a magnetoresistance layer 208 and a hard mask layer 210. The magnetoresistance layer 208 is configured on the second surface 216 of the conductive unit 231, and the hard mask layer 210 is configured on a surface of the magnetoresistance layer 208. A passive protecting layer 225 is formed on the hard mask layer 210 to protect the magnetoresistive structure 212. Generally, the magnetoresistance layer 208 is based on the mechanisms including anisotropic magnetoresistance (AMR), giant magnetoresistance (GMR), tunneling magnetoresistance (TMR), or combination thereof. A material of the magnetoresistance layer 208 can be, but not limited to, ferromagnets, antiferromagnets, ferrimagnets, paramagnetic or diamagnetic metals, tunneling oxides, or combination thereof.

In the present embodiment, after a general semiconductor element or other circuit element (i.e. the conductive unit 231) is formed on the substrate 202, the magnetoresistive structure 212 is formed on the conductive unit 231. Therefore, the magnetic materials such as iron, cobalt and nickel in the magnetoresistive structure 212 will not contaminate the machines used in the subsequent processes. Further, the thermal cycles and stress accumulation in the subsequent metallization processes, especially lithography and etching processes, will not affect the performance and reliability of the magnetoresistive structure 212.

Additionally, in the present embodiment, the conductive unit 231 is configured on the substrate 202 and then the magnetoresistive structure 212 is formed on the conductive unit 231. Here, the hard mask layer 210 of the magnetoresistive structure 212 is only used for defining the magnetoresistance layer 208 and does not serve as electrical contact to the conductive unit 231. Thus the hard mask layer 210 can be electrically conductive, semi-conductive or non-conductive, and can be made of conductors, semiconductors or non-conductors. Further, when the hard mask layer 210 is electrically conductive, taking the material of the hard mask layer 210 is tantalum (Ta) or tantalum nitride (TaN) as an example, it is not necessary for the hard mask layer 210 to have a conventional function of preventing over-etching to the magnetoresistance layer 208 during forming the conductive unit 231. Therefore, a thickness of the conductive hard mask layer 210, for example, can be decreased to be in a range from 100 to 150 angstroms (Å). The thickness of the hard mask layer 210 is less than the thickness of the hard mask layer in the conventional magnetoresistive structure, which is in a range from 300 to 400 angstroms. In addition, the resistance of the hard mask layer 210 can also be higher than the resistance of the magnetoresistance layer 208. Less hard mask thickness results in higher resistance, which helps to reduce current shunting effect through the hard mask layer 210 and therefore improves the magnetoresistance ratio. Accordingly, the magnetoresistance layer 208 cooperated with the thinner hard mask layer 210, improve the sensitivity of magnetic field detection.

In the following embodiments, the material, structure, and process of elements having same reference numerals are identical or similar to that of the aforementioned embodiment, and will not be repeatedly described.

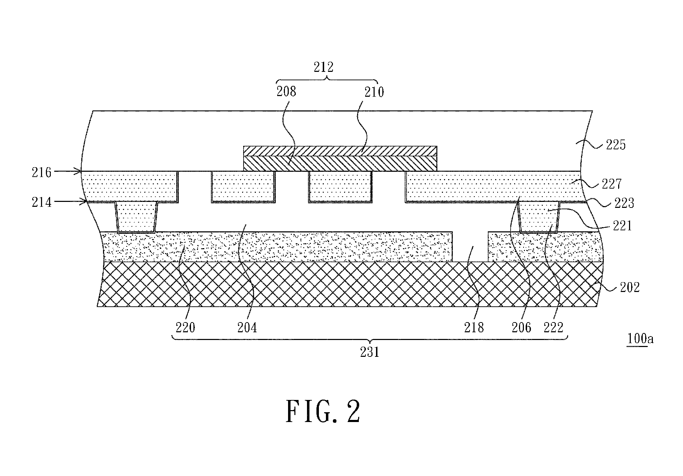

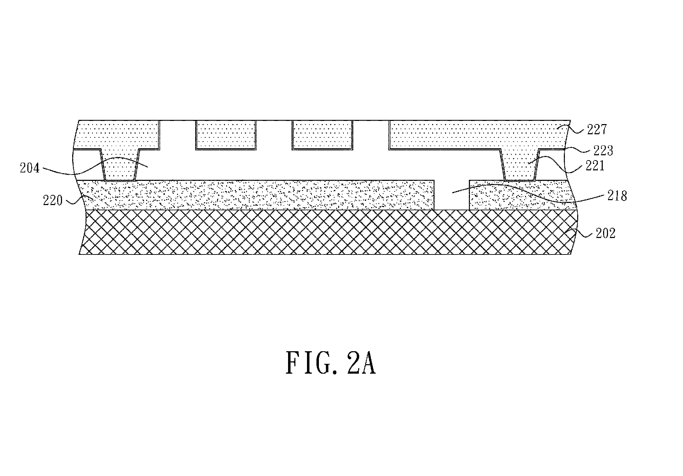

Fig. 2 is a cross-sectional, schematic view of a magnetoresistive sensor in accordance with a second embodiment of the present invention. Referring to Fig. 2, in the present embodiment, to improve the functionality of the magnetoresistive sensor, a magnetoresistive sensor 100a includes a number of conductive layers. The magnetoresistive sensor 100a includes a substrate 202, a conductive unit 231, a magnetoresistive structure 212 and a via-filled conductor 222. The conductive unit 231 is configured on the substrate 202. The conductive unit 231 includes a plurality of routing conductive traces. In the present embodiment, the conductive unit 231 includes a second insulating layer 218 formed on the substrate 202 and a second conductive layer 220 configured in the second insulating layer 218. Further, a first insulating layer 204 is formed on the second conductive layer 220; a first conductive layer 206 is configured in the first insulating layer 204. The via-filled conductor 222 is configured in the first insulating layer 204 and is electrically connected to the first conductive layer 206 and the second conductive layer 220. In the present embodiment, the first conductive layer 206 and the second conductive layer 220 constitute the routing conductive traces. The conductive unit 231 includes the uppermost conductive layer (i.e., the first conductive layer 206).

Usually, the first conductive layer 206 is configured for sensing a resistance change of the magnetoresistive structure 212 in response to a magnetic field variation. The second conductive layer 220 serves as a programming line and is configured for changing or controlling the magnetization direction of the magnetoresistance layer 208. The first insulating layer 204 and the second insulating layer 218 can be a dielectric material of either silicon dioxide or silicon nitride. A material of the first conductive unit 206 can be either tungsten or copper, and a material of the second conductive unit 220 can be either aluminum or copper.

In the present embodiment, other conductive layers are not disposed on the magnetoresistive structure 212, and two conductive layers under the magnetoresistive structure 212 are illustrated as an example. However, the number of the conductive layer is not limited by the present embodiment. That is, more than two conductive layers can be sequentially formed under the magnetoresistance layer 208.

A fabricating method of the magnetoresistive sensors shown in Fig. 2 is described as follows.

Referring to Figs. 2 and 2A, in the method, the substrate 202 is firstly provided, and then the conductive unit 231 is formed on the substrate 202. The step of forming the conductive unit 231 includes forming the first insulating layer 204 on the substrate 202 and forming the first conductive layer 206 in the first insulating layer 204. The first conductive layer 206 is configured for being electrically connected to the magnetoresistive structure 212. The first insulating layer 204 can be a dielectric material such as silicon oxide or silicon nitride, and the material of the first conductive layer 206 can be either tungsten or copper.

The step of forming the magnetoresistive structure 212 includes forming the hard mask layer 210 on the surface of the magnetoresistance layer 208, and then forming the magnetoresistance layer 208 on the second surface 216 of the conductive unit 231. Before forming the magnetoresistive structure 212, a planarization step of the second surface 216 of the conductive unit 231 can be performed. In addition, the passive protecting layer 225 can be formed to entirely cover and protect the magnetoresistive structure 212.

Additionally, in the present embodiment, after the conductive unit 231 is firstly formed on the substrate 202, the magnetoresistive structure 212 is formed on the conductive unit 231.

Considering the functionality and controllability of the magnetoresistive sensors, the magnetoresistive sensor 300 in another embodiment of the present invention includes a number of conductive layers. Referring to Fig. 2A, the second insulating layer 218 is formed on the substrate 202, and the second conductive layer 220 is formed in the second insulating layer 218. The material of the second conductive layer 220 can be either aluminum or copper. Depending on the used material, the sequence of forming the second insulating layer 218 and forming the second conductive layer 220 can be swapped. Afterwards, the first insulating layer 204 is formed on the second conductive layer 220. The first insulating layer 204 and the second insulating layer 218 can be made of a dielectric material such as silicon oxide or silicon nitride. The first conductive layer 206 and the via-filled conductor 222 can be formed together, for example, using a dual damascene process, or separately using twice single damascene processes. In the dual damascene process, the via-filled conductor 222 and the first conductive layer 206 can be made of copper or tungsten. In the twice single damascene processes, the via-filled conductor 222 can be a tungsten plug and the first conductive layer 206 can be made of copper or tungsten. The purpose of the damascene processes here is to provide a flat and smooth surface to meet the demand of the subsequent formed magnetoresistance layer 208. The flat surface helps to maintain the uniform magnetic domain orientation of the magnetoresistance layer and therefore improve the quality of the magnetoresistance signals.

In the present embodiment, the first conductive layer 206 and the via-filled conductor 222 is made of copper and a fabricating process is described as follows. Firstly, the first insulating layer 204 is etched so as to define at least one via hole 221 connecting the first conductive layer 206 and the second conductive layer 220 in the first insulating layer 204. Next, the trench 227 above the via hole 221 is defined. The trench 227 is configured for forming the first conductive layer 206. The pattern of the trench 227 fully encloses the pattern of the via hole 221. Next, a barrier layer 223 is formed on surfaces of the via hole 221 and the trench 227 by a physical or chemical vapor deposition method. The barrier layer 223 can be made of either a tantalum nitride (TaN) layer or a titanium nitride (TiN) layer.

After depositing the barrier layer 223, a thin and uniform copper seed layer (not shown) is formed by a vapor deposition method in the trench 227 and the via hole 221 so as to provide nucleating sites for further copper growth. Thus, a mass of copper can be deposited to fill into the via hole 221 and the trench 227 by using electrical plating process. As a result, the via-filled conductor 222 and the first conductive layer 206 are formed simultaneously. The via-filled conductor 222 can be electrically connected to the first conductive layer 206 and the second conductive layer 220. After that, the redundant copper on the surface is removed using a chemical-mechanical polishing process to achieve a planarization of the second surface 216 of the conductive unit 231.

Thereafter, referring to Fig. 2, the magnetoresistance layer 208 is formed on the planarized second surface 216, using the hard mask layer 210 above for patterning. After forming the magnetoresistive structure 212, the magnetoresistive structure 212 can be covered by the passive protecting layer 225 to protect the magnetoresistive structure 212.

In the present embodiment, the damascene process is used to form the topmost conductive layer. The damascene process provides a flat and smooth surface to meet the demand of subsequent formed magnetoresistive structure. The advantage of using copper conductive layer is its low electrical resistivity (∼1.7 µΩ·cm), which is only two thirds of that of aluminum (∼2.8 µΩ·cm). When copper conductive layer is used, the parasitic resistance due to metal wiring can be reduced and therefore the signal from the magnetoresistance layer can be improved. In addition, the copper conductive layer has better durability against electromigration, thereby reducing the probability of disconnection of conductive traces and improving the reliability of the magnetoresistive sensors.

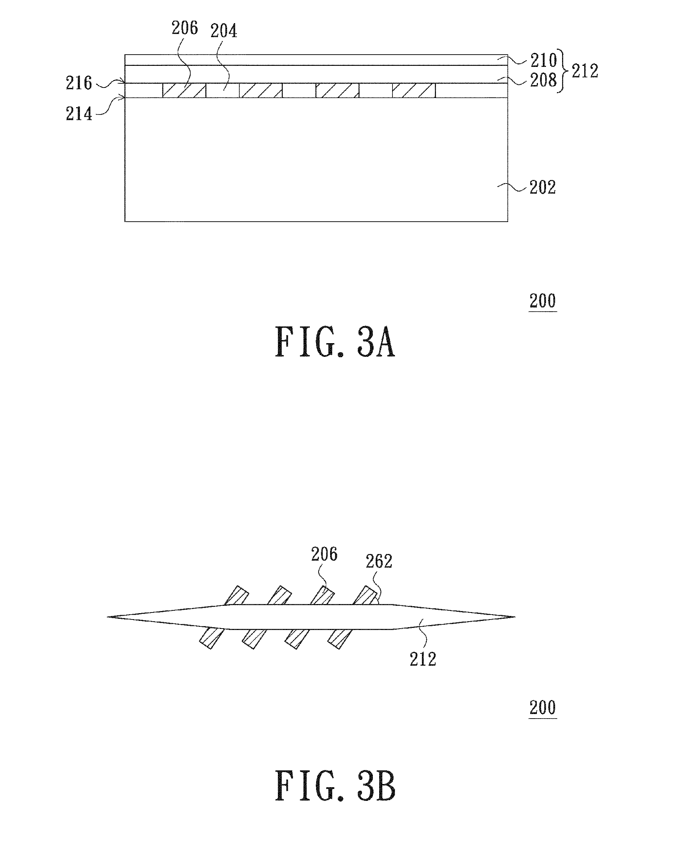

Referring to FIGS. 3A and 3B, a third embodiment also provides a magnetoresistive sensor 200. The magnetoresistive sensor 200 is similar to the magnetoresistive sensor 100 of the first embodiment except the configuration of the first conductive trances. As illustrated in FIG. 3B, a lengthwise extending direction (i.e., the horizontal direction in FIG. 3B) of the magnetoresistive structure 212 is intersected by a lengthwise extending direction of the first conductive traces 206 with a first angle 262, and the first angle 262 is greater than or equal to 0 degree and smaller than or equal to 90 degrees. The magnetoresistive structure 212 is electrically connected with the first conductive traces 206. Moreover, the shape and configuration of the magnetoresistive structure 212 is not limited to those as illustrated in FIG. 3B, and may be any other suitable shape and configuration.

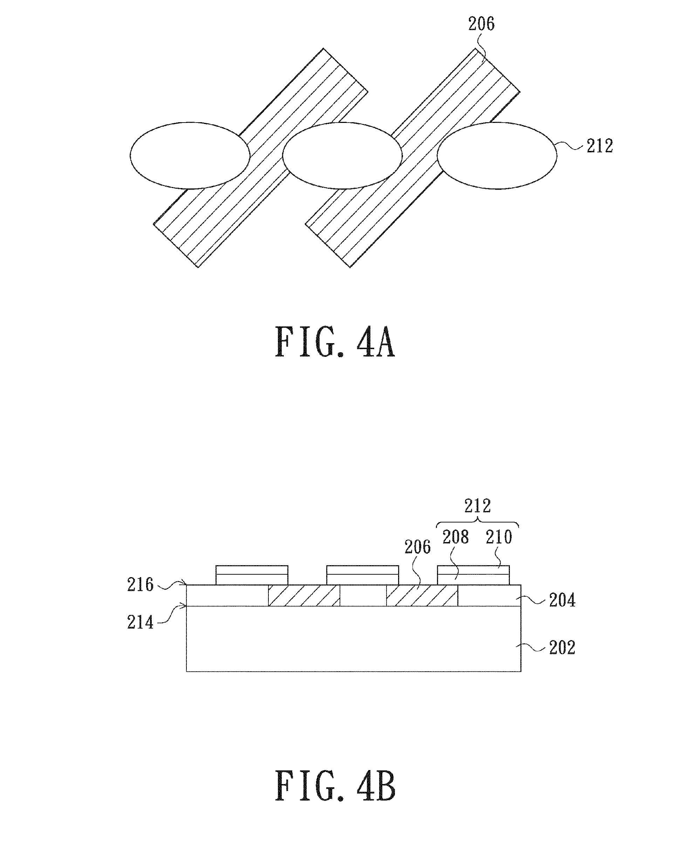

For example, as illustrated in FIG. 4A, according to a second implementation of the third embodiment of the present invention, the magnetoresistive structure 212 can be a discontinuous elliptical structure while the discrete elliptical portions of the magnetoresistive structure 212 are electrically interconnected with the first conductive traces 206.

FIG. 4B shows a schematic cross-sectional view of the magnetoresistive sensor in FIG. 4A. As illustrated in FIG. 4B, the first insulating layer 204 is formed on the substrate 202, and the first conductive traces 206 are formed at the same level as the first insulating layer 204 and arranged in the form of single layer. The layer of first conductive traces 206 has a first surface 214 and a second surface 216 opposite to each other. The first surface 214 faces toward the substrate 202. The discontinuous magnetoresistive structure 212 (including the magnetoresistive layer 208 and the hard mask layer 210) is formed on the first insulating layer 204 and at the side of the second surface 216 of the layer of first conductive traces 206. The discontinuous portions of the magnetoresistive structure 212 are electrically interconnected with the first conductive traces 206.

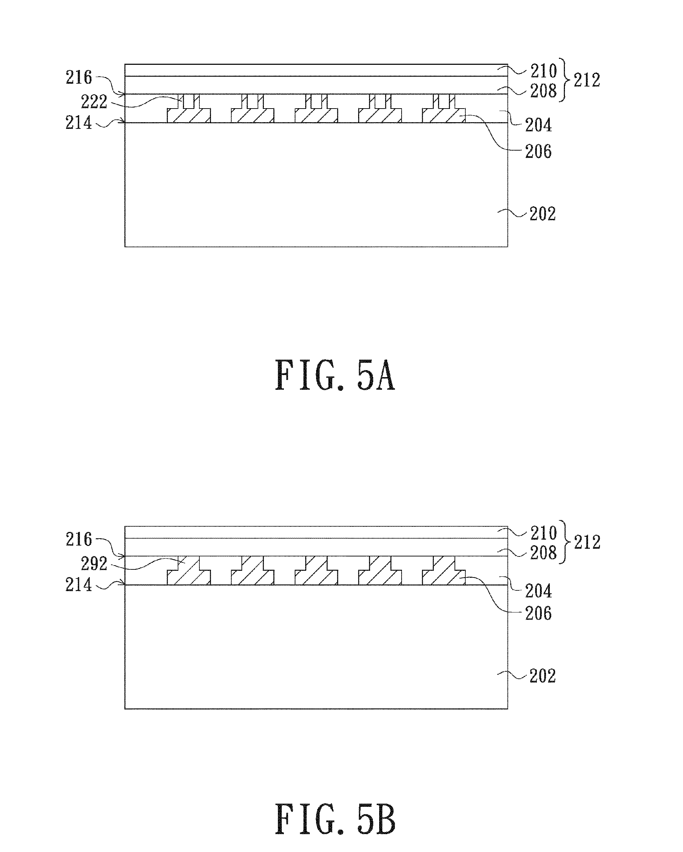

Except the first conductive traces 206 are directly and electrically connected with the magnetoresistive structure 212, in order to improve the planarization effect of a contact interface between the first conductive trace 206 and the magnetoresistive structure 212 and thereby achieve better magnetoresistive characteristic, as illustrated FIG. 5A associated with a third implementation of the third embodiment of the present invention, the first conductive traces 206 can be electrically connected with the magnetoresistive structure 212 by multiple first via-filled conductors 222 penetrating through the first insulating layer 204. In addition, the first via-filled conductors 222 in FIG. 5A can be replaced by multiple first trench-filled conductors 292 as illustrated in FIG. 5B associated with a fourth implementation of the third embodiment instead.

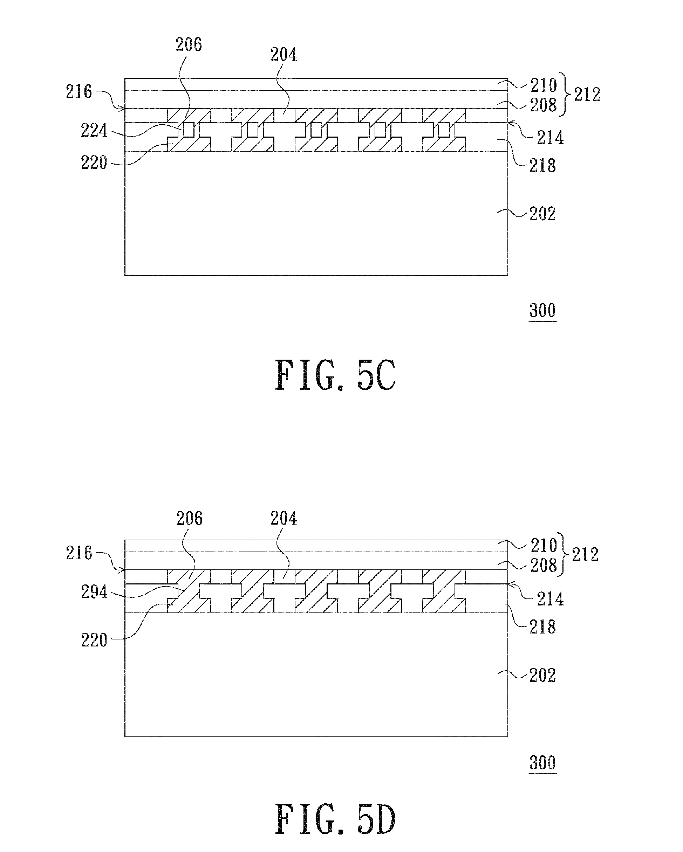

In order to improve the current shunt effect of the first conductive traces 206, the magnetoresistive sensor can be formed with multiple layers of conductive trace, and the multiple layers of conductive trace can be electrically connected in parallel to reduce the resistance thereof. FIG. 5C shows a schematic cross-sectional view of a magnetoresistive sensor in accordance with a fifth implementation of the third embodiment of the present invention. As illustrated in FIG. 5C, the magnetoresistive sensor 300 includes a second insulating layer 218 and second conductive traces 220, besides a first insulating layer 204, first conductive traces 206 and a magnetoresistive structure 212 all formed on the substrate 202. The second insulating layer 218 is formed between the substrate 202 and the first surface 214 of the layer of first conductive traces 206. The second conductive traces 220 are formed at the same level as the second insulating layer 218 and electrically connected with the first conductive traces 206. The second conductive traces 220 are arranged in the form of single layer. A lengthwise extending direction of the second conductive traces 220 is intersected a lengthwise extending direction of the magnetoresistive structure 212 with a second angle. The second angle is greater than or equal to 0 degrees and smaller than or equal to 90 degrees.

In addition, in order to improve the shunt effect of the first conductive traces 206 to thereby achieve the effects of lower resistance and more efficiency, the second insulating layer 218 further is formed with second via-filled conductors 224 therein to electrically connect the first conductive traces 206 with the second conductive traces 220. In a sixth implementation of the third embodiment, as illustrated in FIG. 5D, the first conductive traces 206 are electrically connected with the second conductive traces 220 by multiple second trench-filled conductors 294 instead.

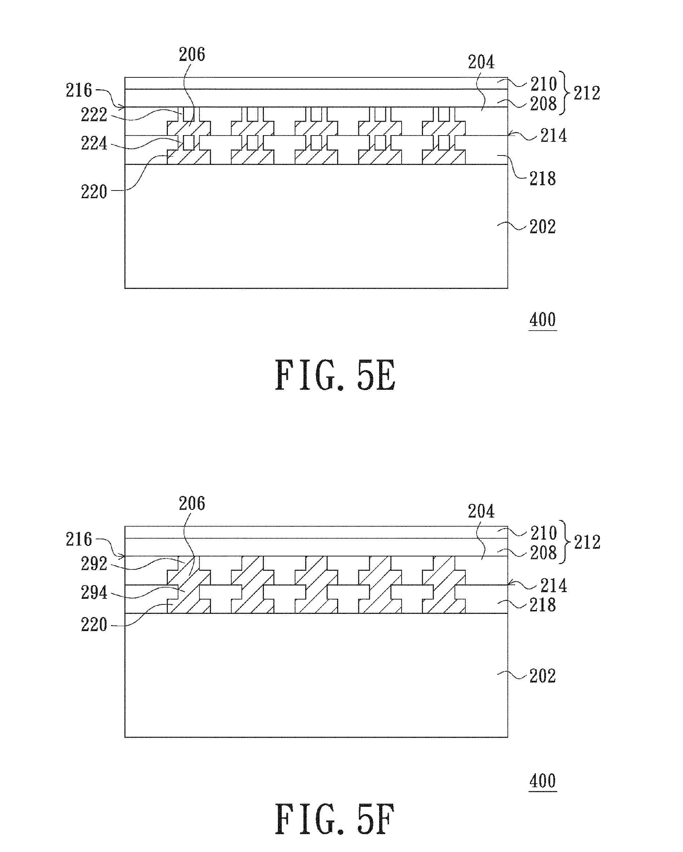

FIG. 5E shows a schematic cross-sectional view of a magnetoresistive sensor in accordance with a seventh implementation of the third embodiment of the present invention. As illustrated in FIG. 5E, in order to improve planarization effect of a contact interface between the first conductive traces 206 and the magnetoresistive structure 212 to thereby achieve better magnetoresistive characteristics, besides the shunt effect of the first conductive trace 206 is improved, the first insulating layer 204 of the magnetoresistive sensor 400 is also formed with first via-filled conductors 222 therein to electrically connect the magnetoresistive structure 212 with the first conductive traces 206. The substrate 202 can be either a silicon substrate covered by a dielectric material or a silicon chip having previously formed logic circuits. The material of the first conductive traces 206, the second conductive traces 220, the first via-filled conductor 222 and the second via-filled conductors 224 can be aluminum (Al), tungsten (W), or copper (Cu) and so on, or one of the combinations thereof. The first insulating layer 204 and the second insulating layer 218 can be silicon oxide layers or silicon nitride layers, etc.

In the illustrative embodiment, although the examples of the second insulating layer 218 formed with the second via-filled/trench-filled conductors 224/294 therein and/or the first insulating layer 204 formed with the first via-filled conductors 222 therein are taken to illustrate the structures of the respective magnetoresistive sensors 300, 400, the amount and size of via-filled/trench-filled conductors of the present invention are not limited to these. In addition, as illustrated in FIG. 5F associated with an eighth implementation of the third embodiment, first trench-filled conductors 292 and second trench-filled conductors 294 are formed to achieve the electrical connections among the magnetoresistive structure 212, the first conductive traces 206 and the second conductive traces 220.

In the illustrative implementations associated with FIGS. 5A through 5F, the magnetoresistive structure 212 is without any conductive trace formed thereabove and is formed with one layer or two layers of conductive trace therebelow to illustrate the structure of the magnetoresistive sensor of the present invention. However, the amount of the layers of conductive trace in the illustrative embodiments is not limited to these, and much more layers of conductive trace can be formed below the magnetoresistive layer 208 in sequence.

Since in the third embodiment of the present invention associated with FIGS. 3A through 5F, the general semiconductor devices such as the conductive traces and/or via-filled/trench-filled conductors are firstly formed on the substrate 202, therefore, these illustrated magnetoresistive sensors also have the advantages as described in the first embodiment. It is noted that, the present invention can use different conductive traces and fabrication process thereof to increase the performance of the magnetoresistive sensor and improve the production manner. Accordingly, in the illustrated structures of various embodiments, the conductive layers (including the layers of conductive trace and the layers of via-filled/trench-filled conductor) may have different combinations, and the amount of the conductive layers connected together is not limited to the foregoing illustrations.

While the invention has been described in terms of what is presently considered to be the most practical and preferred embodiments, it is to be understood that the invention needs not be limited to the disclosed embodiment. On the contrary, it is intended to cover various modifications and similar arrangements included within the scope of the appended claims which are to be accorded with the broadest interpretation so as to encompass all such modifications and similar structures.

## Claims

1. A magnetoresistive sensor, comprising:
a substrate;
a first conductive trace, configured on the substrate, wherein the first conductive trace has a first surface and a second surface opposite to the first surface, the first surface facing toward the substrate; and
a magnetoresistive structure, configured on the second surface and electrically connected to the first conductive trace.

2. The magnetoresistive sensor of claim 1, further comprising:
a first insulating layer, configured on the substrate, wherein the first conductive trace is formed at a level of the first insulating layer.

3. The magnetoresistive sensor of claim 2, further comprising:
a second insulating layer, formed on the substrate;
a second conductive trace, configured in the second insulating layer; and
a first via-filled conductor or a first trench-filled conductor, formed in the second insulating layer and electrically connecting the first conductive trace to the second conductive trace.

4. The magnetoresistive sensor of claim 1, wherein the substrate is a silicon substrate covered by a dielectric material or a silicon chip having previously formed logic circuits.

5. The magnetoresistive sensor of claim 1, wherein the first conductive trace is the uppermost conductive layer of the magnetoresistive sensor.

6. The magnetoresistive sensor of claim 1, wherein the magnetoresistive structure comprises:
a magnetoresistance layer, configured on the second surface of the conductive unit; and
a hard mask layer, configured on a surface of the magnetoresistance layer.

7. The magnetoresistive sensor of claim 1, wherein a lengthwise extending direction of the magnetoresistive structure is intersected with a lengthwise extending direction of the first conductive trace with a first angle, the first angle is greater than or equal to 0 degrees and smaller than or equal to 90 degrees.

8. The magnetoresistive sensor of claim 3, wherein the first insulating layer further is formed with a second via-filled or trench-filled conductor therein, the second via-filled or trench-filled conductor is to electrically connect the magnetoresistive structure with the first conductive trace.

9. The magnetoresistive sensor of claim 8, wherein each of the first conductive trace, the second conductive trace, the first via-filled or trench-filled conductor and the second via-filled or trench-filled conductor is made of one of the group consisting of aluminum, tungsten, copper and combinations thereof, each of the first insulating layer and the second insulating layer is a silicon oxide layer, a silicon nitride layer or a combination thereof.

10. The magnetoresistive sensor of claim 3, wherein a lengthwise extending direction of the second conductive trace is intersected the lengthwise extending direction of the magnetoresistive structure with a second angle, the second angle is greater than or equal to 0 degrees and smaller than or equal to 90 degrees.

11. The magnetoresistive sensor of claim 1, wherein the magnetoresistive structure comprises a plurality of discontinuous segments.
